# EUROPEAN PATENT APPLICATION

(11) **EP 2 603 063 A1**
(43) Date of publication of application: **12.06.2013**
(21) Application number: 12191363.6
(22) Date of filing: 06.11.2012
(51) Int. Cl.: H05K 1/02

(54) **Printed circuit board**

(30) Priority: 10.11.2011 JP 2011246716
(71) Applicant: Canon Kabushiki Kaisha, Tokyo 146-8501 (JP)
(72) Inventor: Ikeda, Shinya, Tokyo 146-8501 (JP)
(74) Representative: TBK

(57) **Abstract**

In a printed wiring board (2) of a printed circuit board, a region for mounting a first semiconductor package (4) is divided into a first region (9) on which first solder ball electrodes (7) are disposed and a second region (10) on which first solder ball electrodes are not disposed, and a region for mounting a second semiconductor package (6) on the back side of the first semiconductor package is located within a region on the back side of the second region.

## Description

### BACKGROUND OF THE INVENTION

### Field of the Invention

The present invention relates to a printed circuit board in which semiconductor packages are mounted on a printed wiring board. In particular, the present invention relates to a printed circuit board in which semiconductor packages are mounted on front and back sides of a printed wiring board such that they face each other.

### Description of the Related Art

Electronic apparatuses, such as mobile phones and video cameras, have been rapidly becoming smaller in recent years. A printed circuit board included in such electronic apparatuses and electronic components mounted on such a printed circuit board have been demanded to achieve both increased functionality and reduced size.

To meet such demands, electronic components have been changed from those called quad flat packages (QFPs) with lead terminals therearound to those having a structure in which electrodes are arranged in a matrix on the back side to achieve higher pin count and reduced size. Some well-known examples of such electronic components include semiconductor packages called a ball grid array (BGA) and a chip size package (CSP). To meet demands for reduced size, such semiconductor packages are mounted on both sides of a printed wiring board in a printed circuit board to reduce the overall size of the electronic apparatus.

However, turning on the electronic apparatus causes semiconductor devices included in the semiconductor packages to generate heat. The heat generated by the semiconductor devices causes expansion and deformation of the semiconductor packages and the printed wiring board having the semiconductor packages mounted thereon.

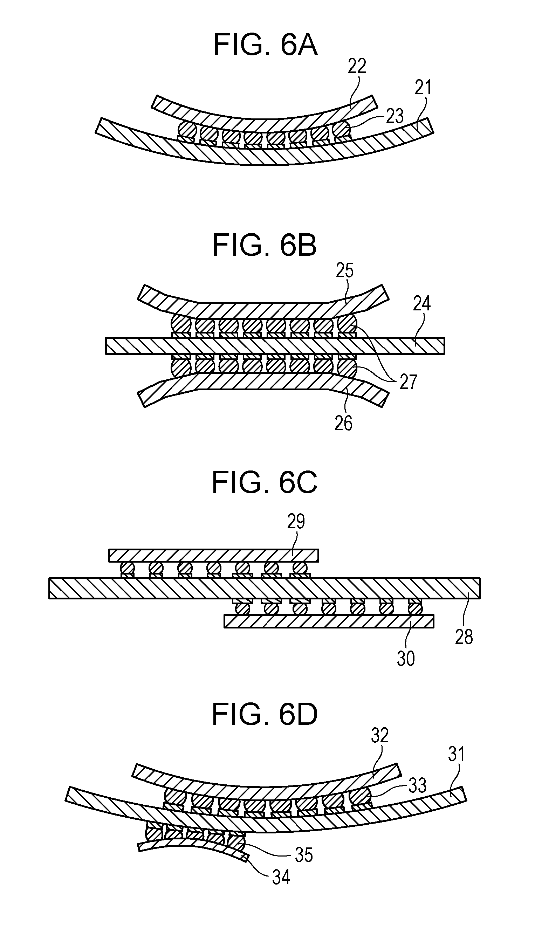

Fig. 6A illustrates a printed circuit board in which a semiconductor package is mounted only on one side of a printed wiring board. The printed circuit board illustrated in Fig. 6A includes a printed wiring board 21, a semiconductor package 22 having a semiconductor device (not shown) mounted therein, and solder ball electrodes 23 serving as connection terminals for joining the printed wiring board 21 to the semiconductor package 22. In this case, heat generated by the semiconductor device mounted in the semiconductor package 22 causes expansion of the semiconductor package 22 and the printed wiring board 21. Due to a difference in coefficient of linear expansion between the semiconductor package 22 and the printed wiring board 21, stress is applied to the solder ball electrodes 23. The semiconductor package 22 and the printed wiring board 21 having the semiconductor package 22 mounted thereon warp to reduce the stress applied to the solder ball electrodes 23.

The coefficient of linear expansion of the semiconductor package 22 in which the semiconductor device made of silicon is mounted is smaller than that of the printed wiring board 21 made of glass epoxy resin or the like. Therefore, as illustrated in Fig. 6A, the semiconductor package 22 and the printed wiring board 21 having the semiconductor package 22 mounted thereon warp together to be raised at both ends (or warp upward).

Fig. 6B is a cross-sectional view of a printed circuit board in which two identical semiconductor packages are mounted on both sides of a printed wiring board such that they face each other. The printed circuit board illustrated in Fig. 6B includes a printed wiring board 24, semiconductor packages 25 and 26 each having a semiconductor device (not shown) mounted therein, and solder ball electrodes 27 for joining the printed wiring board 24 to both of the semiconductor packages 25 and 26. In this case, heat generated by the semiconductor devices mounted in the semiconductor packages 25 and 26 causes expansion of the semiconductor packages 25 and 26 and the printed wiring board 24. Due to a difference in coefficient of linear expansion between the semiconductor packages 25 and 26 and the printed wiring board 24, stress is applied to the solder ball electrodes 27. This causes the semiconductor packages 25 and 26 to warp upward and downward, respectively. However, when stress is applied equally from the front and back sides, the printed wiring board 24 is unable to warp. Therefore, the stress applied to the solder ball electrodes 27 is not reduced and accumulates in the solder ball electrodes 27. This significantly degrades the joint reliability of the solder ball electrodes 27.

To improve the joint reliability of solder ball electrodes, Japanese Patent Laid-Open No. 2004-273617 discloses a configuration in which, as illustrated in Fig. 6C, semiconductor packages 29 and 30 are mounted on the front and back sides of a printed wiring board 28 such that they partially face each other.

However, as the sizes of electronic apparatuses degrease, the frequencies of signals used in such electronic apparatuses increase. Therefore, it is desired to minimize the distance between the semiconductor packages mounted on the front and back sides of the printed wiring board. It is thus necessary to reduce the distance between the semiconductor packages on the front and back sides so as to reduce the length of wiring for connection between the semiconductor packages, thereby maintaining the quality of propagating signals. To maintain signal quality, it is necessary to provide a configuration in which the semiconductor packages are arranged on the front and back sides of the printed wiring board such that they do not face each other, or that they partially face each other as in the case of Japanese Patent Laid-Open No. 2004-273617.

In printed circuit boards, BGA semiconductor packages with much smaller sizes than before have been increasingly used in recent years. As compared to large-sized semiconductor packages, small-sized semiconductor packages are smaller in the diameter of solder ball electrodes, smaller in the area of connection pads, smaller in the number of solder ball electrodes, and thus lower in the strength of joining to the printed wiring board. Additionally, due to their thinner substrates, small-sized semiconductor packages are less rigid than large-sized semiconductor packages.

Fig. 6D illustrates a printed circuit board in which a small-sized semiconductor package and a normal-sized semiconductor package are mounted on both sides of a printed wiring board such that they face each other. The printed circuit board illustrated in Fig. 6D includes a printed wiring board 31, a semiconductor package 32 having a semiconductor device (not shown) mounted therein, solder ball electrodes 33 serving as connection terminals for joining the printed wiring board 31 to the semiconductor package 32, a small-sized semiconductor package 34 having a semiconductor device (not shown) mounted therein and a smaller number of connected terminals than the semiconductor package 32, and solder ball electrodes 35 serving as connection terminals for joining the printed wiring board 31 to the small-sized semiconductor package 34. As can be seen from Fig. 6D, the printed wiring board 31 warps to be raised at both ends (or warps upward), whereas the small-sized semiconductor package 34 warps to be lowered at both ends (or warps downward). This causes large stress to accumulate in the solder ball electrodes 35. Therefore, when the small-sized semiconductor package 34 is mounted on the back side of the normal-sized semiconductor package 32 as illustrated in Fig. 6D, the small-sized semiconductor package 34 suffers degraded joint reliability and short joint life cycle.

### SUMMARY OF THE INVENTION

The present invention provides a high-density printed circuit board which allows semiconductor packages to be mounted on front and back sides of a printed wiring board such that they face each other, without causing degradation in joint life cycle of the semiconductor packages.

The present invention in its first aspect provides a printed circuit board as specified in claims 1 to 3.

Further features of the present invention will become apparent from the following description of exemplary embodiments with reference to the attached drawings.

### BRIEF DESCRIPTION OF THE DRAWINGS

Fig. 1 is a cross-sectional view of a printed circuit board according to a first embodiment.

Fig. 2A and Fig. 2B are plan views of first and second semiconductor packages, respectively.

Fig. 3A and Fig. 3B are plan views of first and second surfaces, respectively, of a printed wiring board according to the first embodiment.

Fig. 4 is a cross-sectional view illustrating a thermally deformed state of the printed circuit board according to the first embodiment.

Fig. 5A and Fig. 5B are a cross-sectional view and a plan view, respectively, of a printed circuit board according to Comparative Example 1.

Fig. 6A to Fig. 6D are cross-sectional views of printed circuit boards according to the related art.

### DESCRIPTION OF THE EMBODIMENTS

### First Embodiment

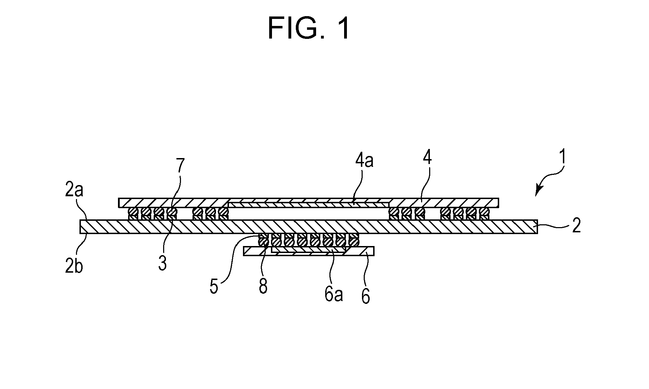

A first embodiment of the present invention will now be described with reference to Fig. 1 to Fig. 4.

Fig. 1 is a cross-sectional view of a printed circuit board 1 according to the first embodiment. The printed circuit board 1 includes a printed wiring board 2, a first semiconductor package 4 mounted on a first surface 2a of the printed wiring board 2, and a second semiconductor package 6 mounted on a second surface 2b of the printed wiring board 2. The second surface 2b is on the back side of the first surface 2a. The first semiconductor package 4 includes a semiconductor device 4a mounted therein, and the second semiconductor package 6 includes a semiconductor device 6a mounted therein.

The first semiconductor package 4 including the semiconductor device 4a is mounted on a first connection pad 3, with solder ball electrodes (first solder ball electrodes) 7 interposed therebetween. The first connection pad 3 is formed on the first surface 2a of the printed wiring board 2. Similarly, the second semiconductor package 6 including the semiconductor device 6a is mounted on a second connection pad 5, with solder ball electrodes (second solder ball electrodes) 8 interposed therebetween. The second connection pad 5 is formed on the second surface 2b of the printed wiring board 2.

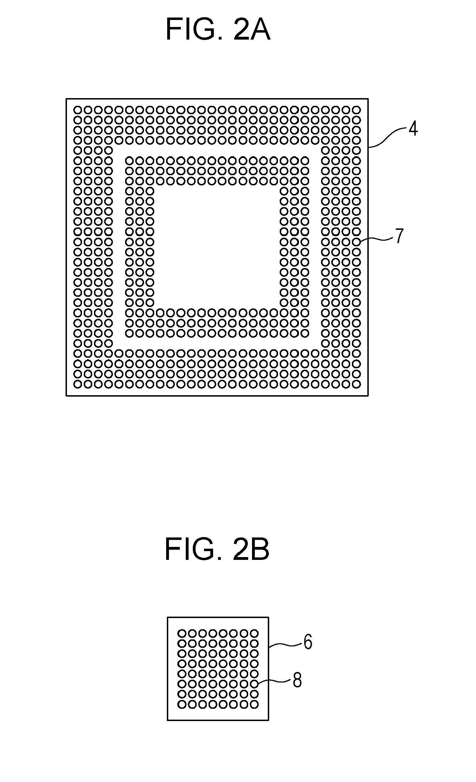

Fig. 2A is a plan view of a lower surface of the first semiconductor package 4 (or surface facing the printed wiring board 2). As illustrated, the solder ball electrodes 7 are arranged on the first semiconductor package 4. Fig. 2B is a plan view of an upper surface of the second semiconductor package 6 (or surface facing the printed wiring board 2). As illustrated, the solder ball electrodes 8 are arranged on the second semiconductor package 6.

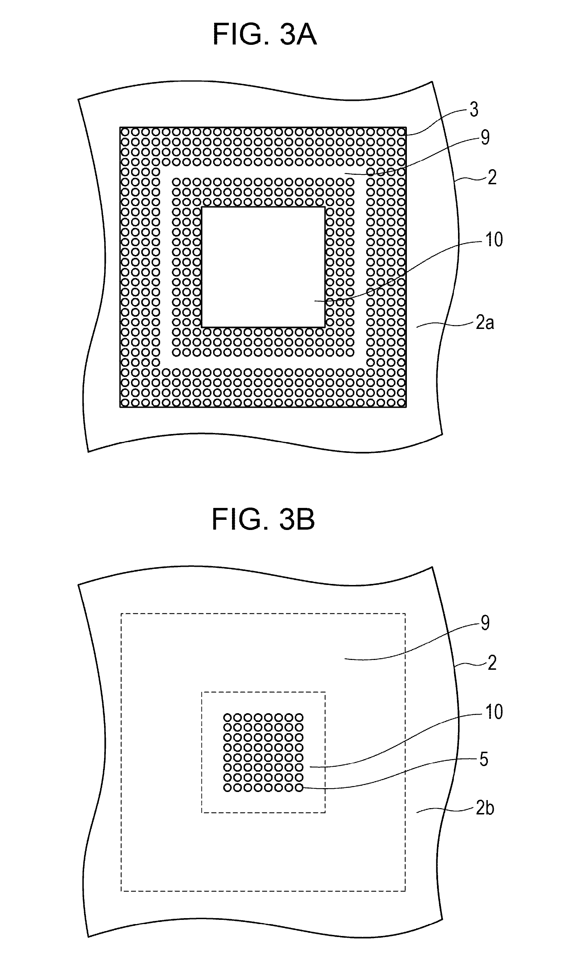

Fig. 3A is a plan view of the first surface 2a of the printed wiring board 2 on which the first semiconductor package 4 is to be mounted. The first connection pad 3 on the first surface 2a is to be disposed on the solder ball electrodes 7 on the first semiconductor package 4. As illustrated in Fig. 3A, a region of the first surface 2a facing the first semiconductor package 4 includes a second region 10 in the center and a first region 9 around the second region 10. The second region 10 is a region where there is no first connection pad 3, whereas the first region 9 is a region where there is the first connection pad 3.

Fig. 3B is a plan view of the second surface 2b of the printed wiring board 2 on which the second semiconductor package 6 is to be mounted. The second connection pad 5 on the second surface 2b is to be disposed on the solder ball electrodes 8 on the second semiconductor package 6. In Fig. 3B, a region facing the second semiconductor package 6 is located within a region on the back side of the second region 10 where there is no first connection pad 3 illustrated in Fig. 3A. For ease of understanding, in Fig. 3B, regions corresponding to the first region 9 and the second region 10 in Fig. 3A are indicated by respective dotted lines. As can be seen from Fig. 3A, the first region 9 is located around the second region 10.

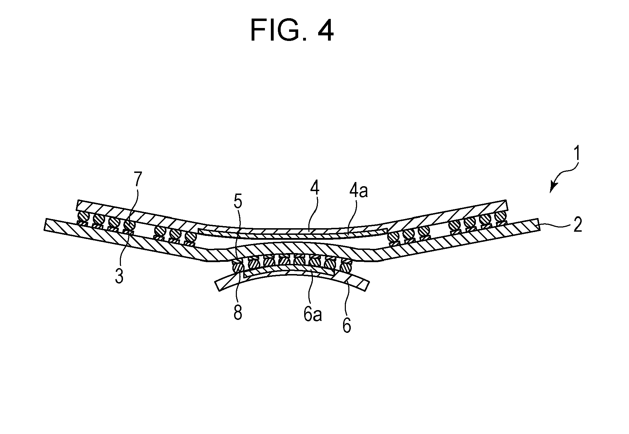

Fig. 4 is a cross-sectional view of the printed circuit board 1 deformed by heat generated by the semiconductor devices 4a and 6a mounted in the semiconductor packages 4 and 6. The printed wiring board 2 and the first semiconductor package 4 are expanded by heat generated by the semiconductor device 4a. The first semiconductor package 4 including the semiconductor device 4a made of silicon has a coefficient of linear expansion smaller than that of the printed wiring board 2 made of glass epoxy resin or the like. Therefore, the printed wiring board 2 and the first semiconductor package 4 have a tendency to warp such that they are raised at both ends. The printed wiring board 2 is provided with no solder ball electrodes 8 in an area opposite the solder ball electrodes 7. Therefore, as in the case of Fig. 6A described above, the printed wiring board 2 and the first semiconductor package 4 warp to be raised at both ends (or warp upward) as illustrated in Fig. 4.

At the same time, the second semiconductor package 6 is expanded by heat generated by the semiconductor device 6a. As in the first semiconductor package 4, the second semiconductor package 6 including the semiconductor device 6a made of silicon has a coefficient of linear expansion smaller than that of the printed wiring board 2. Therefore, the printed wiring board 2 and the second semiconductor package 6 have a tendency to warp such that they are lowered at both ends. The printed wiring board 2 is provided with no solder ball electrodes 7 in an area opposite the solder ball electrodes 8. Therefore, the printed wiring board 2 and the second semiconductor package 6 warp to be lowered at both ends (or warp downward) as illustrated in Fig. 4.

Since the printed wiring board 2 made of glass epoxy resin or the like is deformed more easily than the first semiconductor package 4 and the second semiconductor package 6, the printed wiring board 2 can be deformed in a complex manner as in Fig. 4. That is, in the first region 9, which is an outer region of the printed wiring board 2, the printed wiring board 2 is deformed together with the first semiconductor package 4, whereas in the second region 10, which is an inner region of the printed wiring board 2, the printed wiring board 2 is deformed together with the second semiconductor package 6.

In the present embodiment, the first region 9 where the first semiconductor package 4 is mounted and the second region 10 where the second semiconductor package 6 is mounted are two different regions. Therefore, although the semiconductor packages 4 and 6 are configured to warp in opposite directions, it is possible to fully release the stress applied to the solder ball electrodes 7 and 8 for joining the semiconductor packages 4 and 6, enhance the joint reliability, extend the joint life cycle, and realize high-density mounting.

In the present embodiment, the first region 9 where the first semiconductor package 4 is mounted is located outside the second region 10 where the second semiconductor package 6 is mounted. That is, the first region 9 is located outside the second region 10 in the center of the printed wiring board 2. The present invention is not limited to this, and the second region 10 does not necessarily have to be located in the center inside the first region 9. However, if the second region 10 is located in the center inside the first region 9, the semiconductor packages 4 and 6 can be least affected by warping.

In the present embodiment, in the second surface 2b of the printed wiring board 2 on which the second semiconductor package 6 is mounted, the region facing the second semiconductor package 6 is located within the region on the back side of the second region 10 where there is no first connection pad 3 in the first surface 2a. In the present invention, however, the entire region facing the second semiconductor package 6 does not necessarily have to be located within the region on the back side of the second region 10. It is only necessary that at least the second connection pad 5 to be joined to the solder ball electrodes 8 for mounting the second semiconductor package 6 be located within the region on the back side of the second region 10.

### (Example 1)

Example 1 of the first embodiment will now be described.

The printed wiring board 2 illustrated in Fig. 1 is used as a substrate in electronic apparatuses. Specifically, the printed wiring board 2 is an eight-layer buildup substrate made of glass epoxy resin and measuring 110 mm x 50 mm in overall size and 0.8 mm in thickness.

The first semiconductor package 4 (see Fig. 2A) to be mounted on the printed wiring board 2 measures 13.0 mm x 13.0 mm in overall size and 1.3 mm in thickness. The solder ball electrodes 7 are arranged with a pitch of 0.5 mm and measure 0.3 mm in diameter. The total number of the solder ball electrodes 7 (or pins) is 320. In the center of the first semiconductor package 4, there is a 6.0 mm x 6.0 mm region (corresponding to the second region 10 illustrated in Fig. 3A and Fig. 3B) where there are no solder ball electrodes 7. This structure is generally referred to as a peripheral structure.

The second semiconductor package 6 (see Fig. 2B) to be mounted on the back side of the first semiconductor package 4 measures 5.5 mm x 5.5 mm in overall size and 1.1 mm in thickness. The solder ball electrodes 8 are arranged with a pitch of 0.5 mm and measure 0.3 mm in diameter. The second semiconductor package 6 is a small-sized semiconductor package where the total number of the solder ball electrodes 8 (or pins) is 64. The second semiconductor package 6 is mounted within a region facing the second region 10 of the printed wiring board 2. In other words, the second semiconductor package 6 is mounted such that the entire second connection pad 5 for connecting the second semiconductor package 6 is placed within the region facing the second region 10.

A thermal stress test was performed to measure the durability of each solder ball electrode of the printed circuit board 1. One cycle of the thermal stress test involved placing the printed circuit board 1 inside a chamber, holding the printed circuit board 1 at -25°C for 9 minutes, heating the atmosphere to 125°C in 1 minute, holding the printed circuit board 1 again at 125°C for 9 minutes, and cooling the atmosphere to -25°C in 1 minute. In the printed circuit board 1 of Example 1, the solder ball electrodes 8 at the corners of the second semiconductor package 6 were broken after 380 cycles. The detection of the breakage was determined when the resistance of each solder ball electrode measured online was increased 10% or more.

In thermal stress tests, printed circuit boards proven to withstand 260 to 310 cycles or more are generally determined to be non-defective. This means that the printed circuit board 1 of Example 1 fully satisfied this requirement. The determination of a non-defective product in the thermal stress test was made by taking into account reported data ("Formula for predicting thermal fatigue life of lead-free solder" presented at the reporting session on environment-conscious advanced packaging technology in 2011) from Japan Electronics and Information Technology Industries Association (JEITA).

### (Comparative Example 1)

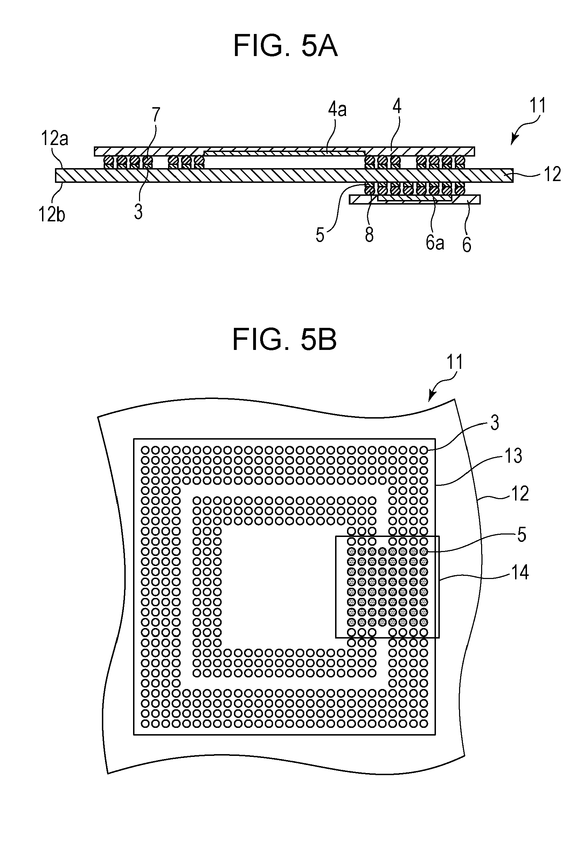

Fig. 5A is a cross-sectional view of a printed circuit board 11 according to Comparative Example 1. In Fig. 5A, the same components as those illustrated in Fig. 1 are given the same reference numerals. In the printed circuit board 11, the first semiconductor package 4 is mounted on a first surface 12a of a printed wiring board 12, and the second semiconductor package 6 is mounted on a second surface 12b of the printed wiring board 12. The first semiconductor package 4 is mounted on the printed wiring board 12 with the first connection pad 3 and the solder ball electrodes 7 interposed therebetween. Similarly, the second semiconductor package 6 is mounted on the printed wiring board 12 with the second connection pad 5 and the solder ball electrodes 8 interposed therebetween. In Comparative Example 1, the dimensions of the printed wiring board 12, the first semiconductor package 4, and the second semiconductor package 6 are the same as those in Example 1 described above. Again, the first semiconductor package 4 includes the semiconductor device 4a mounted therein, and the second semiconductor package 6 includes the semiconductor device 6a mounted therein.

Fig. 5B is a plan view illustrating an overlapping portion of the first connection pad 3 and the second connection pad 5 of the printed circuit board 11, as viewed through the first semiconductor package 4 from above. Note that reference numeral 13 indicates an outline of the first semiconductor package 4, and reference numeral 14 indicates an outline of the second semiconductor package 6. The first connection pad 3 to which the solder ball electrodes 7 on the first semiconductor package 4 are joined and the second connection pad 5 to which the solder ball electrodes 8 on the second semiconductor package 6 are joined are disposed on the front and back sides, respectively, of the printed wiring board 12 such that they face each other. As illustrated in Fig. 5B, 56 out of 64 terminals of the second connection pad 5 coincide with the respective terminals of the first connection pad 3.

In Comparative Example 1, the printed wiring board 12 is restrained from both the front and back sides in a region sandwiched between the solder ball electrodes 7 and 8. Therefore, since the printed wiring board 12 is unable to follow the expansion and warping of the semiconductor packages 4 and 6, the printed wiring board 12 is subjected to stress and degraded in durability.

The same thermal stress test as that in Example 1 was performed to measure the durability of each solder ball electrode of the printed circuit board 11. After 250 cycles of the thermal stress test on the printed circuit board 11, the solder ball electrodes 8 at the corners of the second semiconductor package 6 were broken.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. In a printed wiring board (2) of a printed circuit board, a region for mounting a first semiconductor package (4) is divided into a first region (9) on which first solder ball electrodes (7) are disposed and a second region (10) on which first solder ball electrodes are not disposed, and a region for mounting a second semiconductor package (6) on the back side of the first semiconductor package is located within a region on the back side of the second region.

## Claims

1. A printed circuit board comprising:
a printed wiring board (2);
a first semiconductor package (4) mounted on a first surface (2a) of the printed wiring board with first solder ball electrodes (7) interposed therebetween; and
a second semiconductor package (6) mounted on a second surface (2b) of the printed wiring board with second solder ball electrodes (8) interposed therebetween, the second surface being on the back side of the first surface, the second semiconductor package being smaller in size than the first semiconductor package,
wherein a region of the printed wiring board on which the first semiconductor package is mounted, the region facing the first semiconductor package, includes a first region (9) on which the first solder ball electrodes are disposed and a second region (10) on which the first solder ball electrodes are not disposed; and
a region of the printed wiring board on which the second semiconductor package is mounted, the region having the second solder ball electrodes formed thereon, is located within a region of the printed wiring board, the region being on the back side of the second region.

2. The printed circuit board according to Claim 1, wherein a region of the printed wiring board on which the second semiconductor package is mounted, the region facing the second semiconductor package, is located within a region of the printed wiring board, the region being on the back side of the second region.

3. The printed circuit board according to Claim 1 or 2, wherein the first region is located around the second region.
